# EUROPEAN PATENT APPLICATION

(11) **EP 4 794 170 A1**
(43) Date of publication of application: **19.08.2026**
(21) Application number: 26157449.5
(22) Date of filing: 10.02.2026
(51) Int. Cl.: H02J 7/34, H03F 3/217, B60L 58/10

(54) **SYSTEM AND METHOD FOR PREVENTING DAMAGE TO SWITCHES FOR AN AMPLIFIER IN A VEHICLE**

(30) Priority: 12.02.2025 US 202563757491 P; 30.01.2026 US 202619464926
(71) Applicant: Harman Becker Automotive Systems, Inc., Novi, MI 48377 (US)
(72) Inventor: LIU, Chong, Ann Arbor, 48105 (US); JIANG, Lintong, Canton, 48187 (US); CHEN, Zhijun, Kawasaki, 215-0023 (JP); XU, Peiyue, Northville, 48167 (US)
(74) Representative: Rummler, Felix

(57) **Abstract**

In at least one embodiment, an audio system (100) including an audio arrangement (110), a power management circuit (106), and at least one controller (104) is provided. The audio arrangement (110) is programmed to transmit an audio output signal via at least one loudspeaker (130) in response to an audio input signal. The power management circuit (106) includes at least one first switch (107) being operably coupled to at least one battery (112). The power management circuit (106) is configured to transmit a voltage from the at least one battery (112) to the audio arrangement (110) to power the audio arrangement (110) to transmit the audio output signal. The at least one controller (104) is programmed to selectively activate the at least one first switch (107) to charge a capacitor (108) to a predetermined charge level to prevent an in-rush of current from being delivered to the electronics of the audio arrangement (110) while the at least one battery (112) experiences a fault condition.

## Description

### CROSS-REFERENCE TO RELATED APPLICATION

This application claims benefit to U.S. provisional application Serial No. 63/757,491 filed on February 12, 2025, the disclosure of which is hereby incorporated in its entirety by reference herein.

### TECHNICAL FIELD

Aspects disclosed generally related to a system and method for preventing damage to one or more switches for an audio amplifier. These aspects and others will be discussed in more detail herein.

### BACKGROUND

Generally, for automotive applications, audio amplifiers may have to undergo a short to battery test. Such a test may be utilized to ensure that various electronics (e.g., power transistors) positioned in the audio amplifier are not damaged when the test is performed. In particular, various switches positioned in the amplifier may fail when the short-to-battery test is performed. With Original Equipment Manufacturers (OEMs) requiring that vehicles move from a 12-volt system to a 48-volt system, such a requirement may pose additional issues/concerns over the electronics of an audio amplifier being able to survive the short to battery test.

### SUMMARY

In at least one embodiment, an audio system including an audio arrangement, a power management, a power management circuit, and at least one controller is provided. The audio arrangement includes electronics is programmed to transmit an audio output signal via at least one loudspeaker in response to an audio input signal. The power management circuit includes at least one first switch being operably coupled to at least one battery. The power management circuit is configured to transmit a voltage from the at least one battery to the audio arrangement to power the audio arrangement to transmit the audio output signal. The at least one controller is programmed to selectively activate the at least one first switch to charge at capacitor in a vehicle to a predetermined charge level to prevent an in-rush of current from being delivered to the electronics of the audio arrangement while the at least one battery experiences a fault condition.

In at least another embodiment, an audio system including an audio arrangement, a power management, a power management circuit, and at least one controller is provided. The audio arrangement includes electronics and is programmed to transmit an audio output signal via at least one loudspeaker in response to an audio input signal. The power management circuit includes a first plurality of switches and a diode being operably coupled to at least one battery. The power management circuit is configured to transmit a voltage from the at least one battery to the audio arrangement to power the audio arrangement to transmit the audio output signal. The at least one controller is programmed to selectively deactivate the first plurality of switches to enable a current from the at least one battery to be delivered to the diode of the power management circuit to prevent an in-rush of current from being delivered to the electronics of the audio arrangement while the at least one battery experiences a fault condition.

In at least another embodiment, a method for an audio system is provided. The method includes responsive to detecting a battery experiencing a fault condition, deactivate, via a power management circuit, at least one of a plurality of switches to prevent an in-rush current from the battery being transferred to an audio arrangement.

### BRIEF DESCRIPTION OF THE DRAWINGS

The embodiments of the present disclosure are pointed out with particularity in the appended claims. However, other features of the various embodiments will become more apparent and will be best understood by referring to the following detailed description in conjunction with the accompany drawings in which:
FIGURE 1 illustrates one example of an audio system for a vehicle;
FIGURE 2 illustrates another example of the audio system for vehicle;
FIGURE 3 illustrates another example of the audio system of the vehicle;
FIGURE 4 illustrates another example of the audio system of the vehicle;
FIGURE 5 illustrates another example of the audio system of the vehicle;
FIGURE 6 illustrates an audio system of the vehicle in accordance with one embodiment; and
FIGURE 7 illustrates another audio system of the vehicle in accordance with one embodiment.

### DETAILED DESCRIPTION

As required, detailed embodiments of the present invention are disclosed herein; however, it is to be understood that the disclosed embodiments are merely exemplary of the invention that may be embodied in various and alternative forms. The figures are not necessarily to scale; some features may be exaggerated or minimized to show details of particular components. Therefore, specific structural and functional details disclosed herein are not to be interpreted as limiting, but merely as a representative basis for teaching one skilled in the art to variously employ the present invention.

Generally, automotive systems undergo a short to battery test during development. This may be performed to a number of systems in the vehicle. For example, an automotive audio system also generally undergoes this test to ensure that electronics for the audio system can withstand the in-rush of current. This condition may be more problematic when vehicle systems utilize a 48V battery system. To ensure a reliable audio system, end item supplier for amplifiers and loudspeakers may utilize different approaches. Such approaches include: (i) strengthening the overall design and architecture for metal-oxide-semiconductor field-effect transistors (MOSFETs) in a half bridge topology, (ii) adding switch protection, (iii) adding parallel diode(s) outside of the half-bridge, or (iv) powering the half-bridge at all times (e.g., while the system is operational) and at different rates. However, in some regards, at least items (i) - (iii) as noted above may increase cost for an audio system. Similarly, adding parallel diode(s) may lower electromagnetic compatibility (EMC) performance.

Aspects disclosed herein may provide an audio system that enables, among other things, a simpler power supply path with a small leakage current such that the inrush current as exhibited during the short to battery test may be mitigated. Further, the aspects disclosed herein generally avoid a system cost penalty where system reliability remains unaffected. These aspects and others will be discussed in more detail herein.

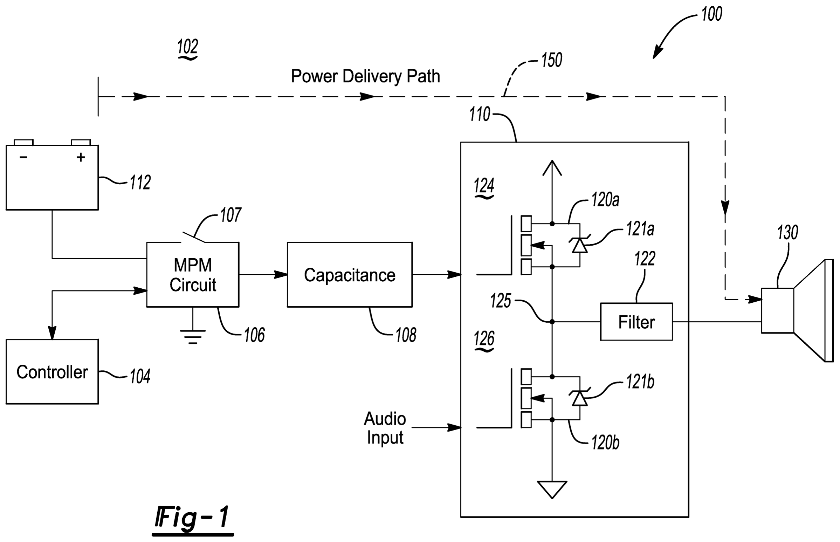

FIGURE 1 illustrates one example of an audio system 100 (or the system 100) for a vehicle 102. The system 100 includes at least one controller 104 ("the controller 104"), a main power management circuit 106, a bulk capacitance 108, and an audio arrangement 110. One or more batteries 112 (the "battery 112") positioned in the vehicle 102 may be operably coupled to the main power management circuit 106, the bulk capacitance 108, and the audio arrangement. 110. The battery 112 may provide power (or a voltage) to the main power management circuit 106, the bulk capacitance 108, and the audio arrangement 110 to power the same. The battery 112 may provide a voltage of anywhere from 12 to 50 Volts.

The controller 104 may be part of the main power management circuit 106. Additionally or alternatively, the controller 104 may be separate from the main power management circuit 106. The main power management circuit 106 may include any number of switching devices 107 (hereafter the switching device 107). The controller 104 may be programmed to monitor a voltage level of the battery 112 for both over voltage and under voltage conditions. The switching device 107 of the main power management circuit 106 may be implemented as metal oxide semiconductor field effect transistors (MOSFETS). In general, the switching device 107 enables the flow of energy from the battery 112 to the audio arrangement 110. The bulk capacitance 108 generally corresponds to capacitance that is inherently present in the overall wiring of the system 100.

The audio arrangement 110 generally includes a plurality of switches 120a - 120b and a filter 122. In one example, each of the switches 120a - 120b may also be MOSFETs. The switches 120a - 120b may form a half bridge circuit. A diode 121a and 121b is positioned in parallel with the respective switch 120a, 120b. In one example, the filter 122 may be a low pass filter. While not shown, the audio arrangement 110 may include a digital signal processor (DSP) 124 and an amplifier 126. The DSP 124 may receive an audio input signal and process the same for playback via at least one loudspeaker 130 positioned in the vehicle 102. The DSP 124 provides the processed audio signal to the switches 120a, 120b where the half bridge formed by the switches 120a, 120b are selectively controlled by the DSP 124 to create a pulsating output voltage at a midpoint 125 of the switches 120a - 120b. The diodes 121a and 121b remove or resolve any freewheeling (or undesired) current that are output by the switches 120a, 120b.

It is recognized that the switches 120a and 120b along with the diodes 121a and 121b may form at least a portion of the amplifier 126 which amplifies the audio input signal to provide an audio output signal. The switches 120a and 120b provide the audio output signal to the filter 122 to filter the same. The filter 122 provides the filtered audio output signal to the loudspeaker 130 for playback in the vehicle 102. A power delivery path 150 illustrates the flow of energy from the battery 112 to the audio arrangement 110 during normal operation.

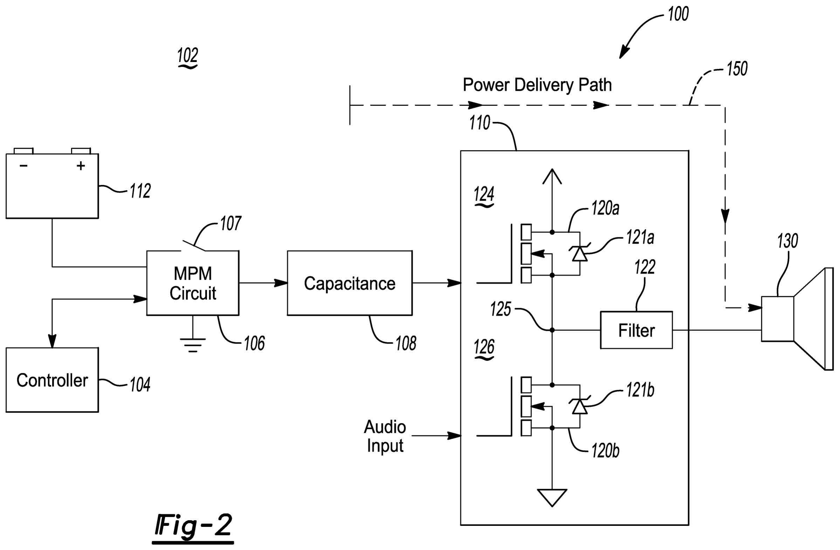

FIGURE 2 illustrates another example of the audio system 100 for the vehicle 102. The audio system 100 as illustrated in connection with FIGURE 2 generally illustrates the power delivery path 150 when the system 100 is undergoing a short to battery test. As noted above, OEMs generally require that audio systems undergo a short to battery test to ensure that the audio system 100 is capable of remaining operational in the event the battery 112 is inadvertently shorted to ground by a user. During a short to battery condition (or test), the controller 104 may detect the short to battery condition and open the switch 107. Even though the switch 107 is open, a reverse in-rush current may be transferred to the audio arrangement 110 in response to the switch 107 being open during the short to battery condition. Thus, as shown the power delivery path 150 may correspond to the reverse in-rush of current that is transferred to the audio arrangement 110 for a moment of time. The reverse in-rush of current may be greater than 100A. In this case, the amount of in-rush current that is temporarily transferred to the switches 120a and 120b may damage the switches 120a and 120b and/or other electronics that form the audio arrangement 110.

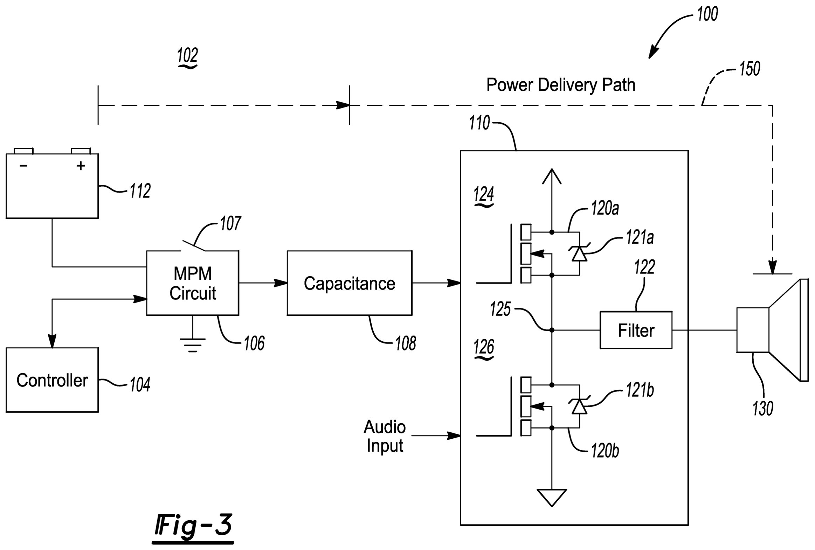

FIGURE 3 illustrates another example of the system 100 for the vehicle 102. The system 100 as illustrated in connection with FIGURE 3 also generally illustrates the power delivery path 150 when the system 100 is undergoing a short to battery test. In this example, the switch 107 remains closed during the short to battery test. This condition removes the potential issue of the reverse in-rush current as noted in connection with FIGURE 2. However, by keeping the switch 107 closed, this condition may give rise to system reliability during when the battery 112 experiences a short condition. Specifically, the system 100 in this arrangement lacks the capacity to disable the battery 112 when the battery 112 experiences the short condition. In the event the battery 112 is configured to provide a voltage in the range of 48 volts (or greater), this condition may jeopardize the overall reliability of the components in the system 100.

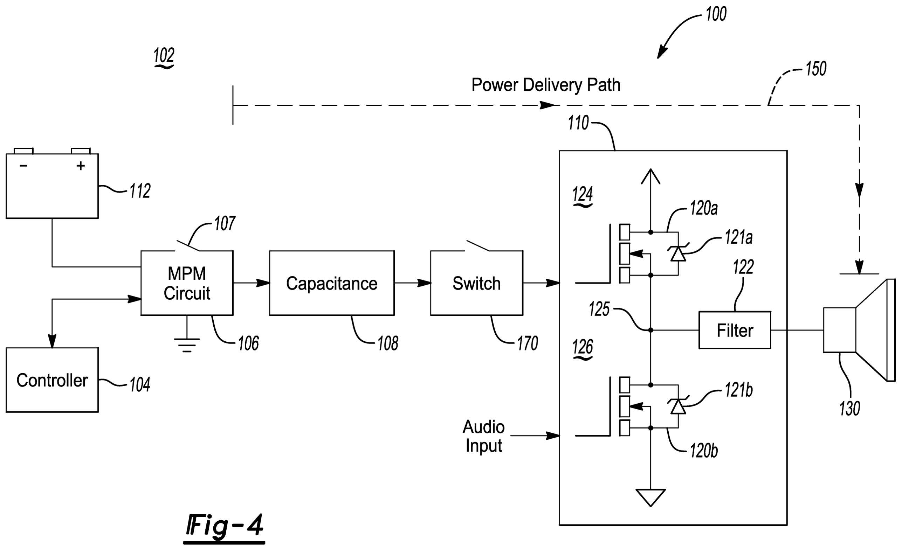

FIGURE 4 illustrates another example of the system 100 for the vehicle 102. The system 100 as illustrated in connection with FIGURE 4 also generally illustrates the power delivery path 150 when the system 100 is undergoing a short to battery test. In this example, system 100 includes an additional switch 170 positioned between the capacitance 108 and the audio arrangement 110.

The controller 104 may open and close the additional switch 170. For example, the controller 104 may open the additional switch 170 when the battery 112 is exhibiting a short condition or when the system 100 executes a battery to short test. In this case, the controller 104 may open the additional switch 170 to prevent excessive energy from being transferred from the battery 112 to the audio arrangement 110. However, energy stored in the capacitance 108 may provide a large in-rush of current in response to the additional switch 170 being opened during a battery 112 to short condition. In this case, the in-rush current may be transferred back to the audio arrangement 110 which may damage one or more of the switches 120a and 120b or various electronics positioned in the audio arrangement 110. This aspect may be more prevalent in the event the battery 112 provides a voltage of up to 50 volts. In addition, the implementation of the additional switch 170 increases overall cost for the system 100.

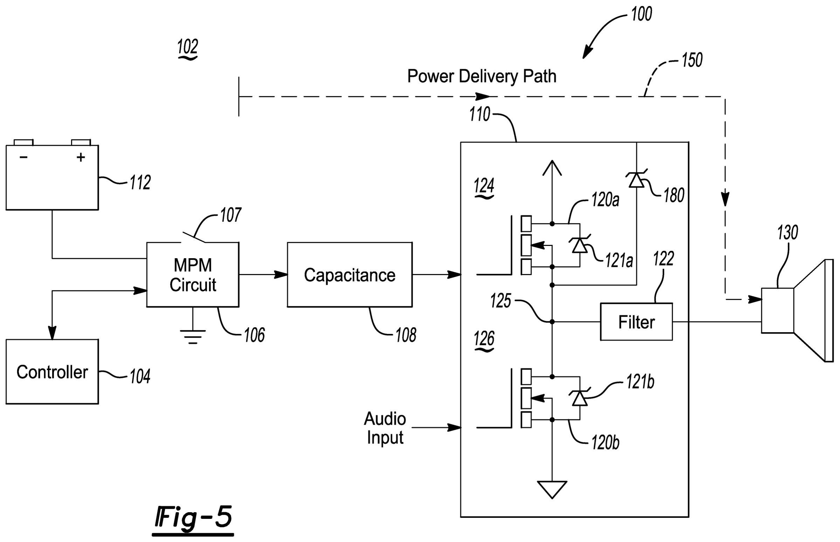

FIGURE 5 illustrates another example of the system 100 for the vehicle 102. The system 100 as illustrated in connection with FIGURE 5 also generally illustrates the power delivery path 150 when the system 100 is undergoing a short to battery test. In this example, the system 100 includes an additional diode 180 positioned in parallel with the switch 120a. The additional diode 180 may mitigates the in-rush current issue since the diode 180 is biased to prevent current flow when the system 100 undergoes the battery to short test or the battery 112 actually experiences a short circuit condition. However, the additional diode 180 increases cost. The parasitic caps of the additional diode 180 may reduce EMC performance for the system 100.

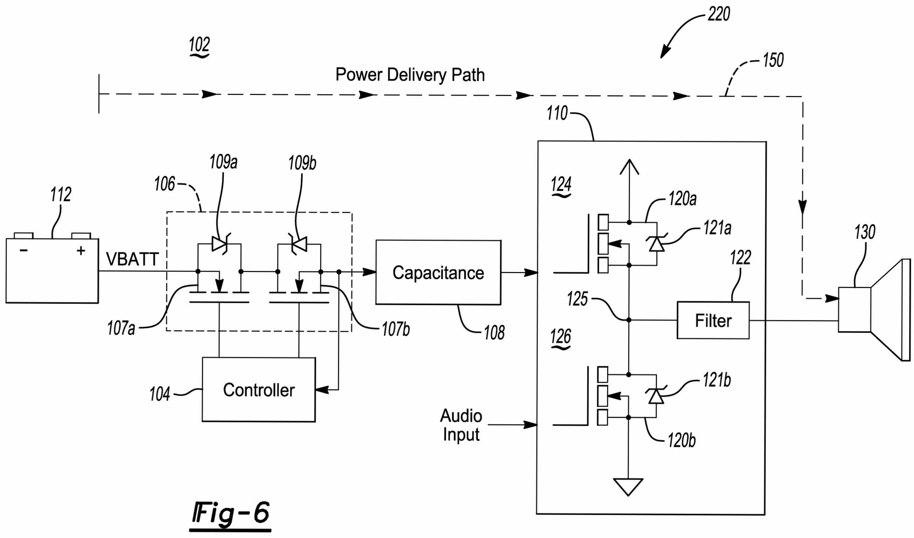

FIGURE 6 illustrates a first audio system 220 for the vehicle 102 in accordance with one embodiment. In one example, the first audio system 220 as illustrated in connection with FIGURE 6 also generally illustrates the power delivery path 150 when the first audio system 220 is undergoing a short to battery test or the battery 112 actually undergoes a short condition during vehicle operation. The first audio system 220 includes the controller 104, the main power management circuit 106, the capacitance 108, and the audio arrangement 110. The main power management circuit 106 includes a first switch 107a and a second switch 107b. In general, each of the first switch 107a and the second switch 107b may be implemented as MOSFETs. A first diode 109a is positioned in parallel with the first switch 107a. A second diode 109b is positioned in parallel with the second switch 107b. The first diode 109a provides a path for current to flow when the first switch 107a is deactivated (or in an OFF state). The first diode 109a protects the first switch 107a from a reverse voltage surge. Similarly, the second diode 109b provides a path for current to flow when the second switch 107b is deactivated (or in the OFF state). The second diode 109b protects the second switch 107b from a reverse voltage surge.

The controller 104 may regularly activate one or more of the switches 120a and 120b such that the one or more of the switches 120a and 120b provide a predetermined voltage to keep the capacitance 108 charged to a predetermined charge level. In one example, the controller 104 may activate the controller 104 to activate the switch 120a and/or the switch 120b to provide a voltage to the capacitance 108 such that the capacitance 108 maintains a charge somewhere between 50 and 80%. The controller 104 may monitor the output voltage provided by the first switch 120a and/or the second switch 120b which ensures that the capacitance 108 is charged to the predetermined charge level. In the event the output voltage provided by the first switch 120a and/or the second switch 120b fall below the predetermined voltage, the controller 104 activates the first switch 120a and/or the second switch 120b to generate a voltage that is equivalent to the predetermined voltage to ensure that the capacitance 108 maintains the predetermined charge level.

The above noted operation generally corresponds to a providing a leakage path in the first audio system 220. Given that the capacitance 108 is charged to the predetermined charge level, this condition prevents the various electronics of the audio arrangement 110 from experiencing damage during a battery to short condition. In particular, this condition mitigates the issue of the inrush of current that flows back to the audio arrangement 110 which may preserve the operational integrity of the switches 120a and 120b (or the half bridge circuit).

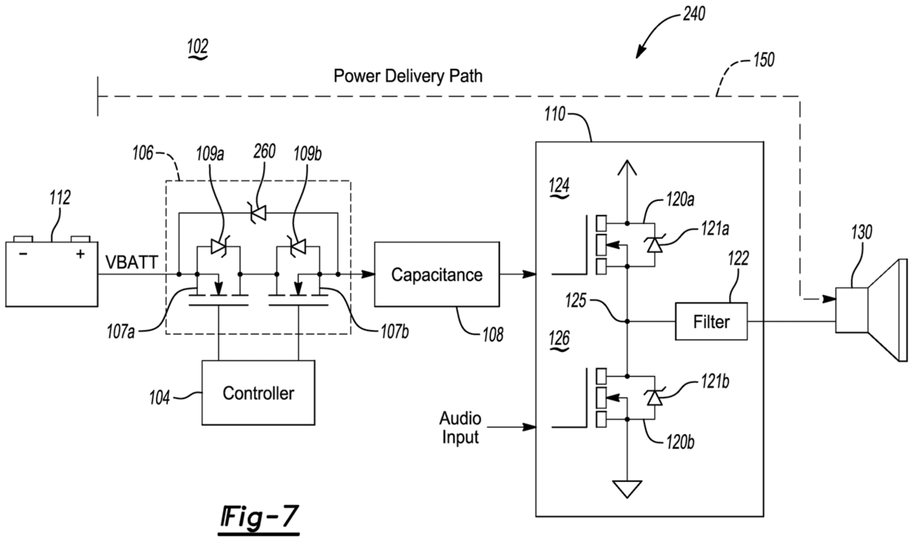

FIGURE 7 illustrates a second audio system 240 for the vehicle 102 in accordance with one embodiment. In one example, the audio system 100 as illustrated in connection with FIGURE 7 also generally illustrates the power delivery path 150 when the second audio system 240 is undergoing a short to battery test or the battery 112 actually undergoes a short condition during vehicle operation. Similar to the first audio system 220, the second audio system 240 includes the controller 104, the main power management circuit 106, the capacitance 108, and the audio arrangement 110. The main power management circuit 106 includes the first switch 107a, the second switch 107b, the first diode 109a, and the second diode 109b. The main power management circuit 106 also includes a diode 260 that is positioned in parallel with the first switch 107a, the second switch 107b, the first diode 109a, and the second diode 109b. In one example, the diode 260 may be a Schottky diode.

In general, the addition of the diode 260 serves as a current leakage path in moments in which the second audio system 240 undergoes the short to battery condition. For example, upon the controller 104 detecting that the short to battery condition has occurred (e.g., the controller 104 detects that the incoming current exceeds a maximum current amount), the controller 104 deactivates the first switch 107a and the second switch 107b. In this case, the diode 260 is orientated to block the flow of current that is transferred from the battery 112 to the audio arrangement 110. While the diode 260 may block a significant and/or a majority amount of current that is being transferred from the battery 112, a small amount of current may pass through the diode 260. The amount of current that passes through the diode 260 may be small enough within one or more predetermined threshold to avoid damaging the first and the second switches 120a, 120b (or other electronics) of the audio arrangement 110.

It recognized that the controllers as disclosed herein may include various microprocessors, integrated circuits, memory devices (e.g., FLASH, random access memory (RAM), read only memory (ROM), electrically programmable read only memory (EPROM), electrically erasable programmable read only memory (EEPROM), or other suitable variants thereof), and software which co-act with one another to perform operation(s) disclosed herein. In addition, such controllers as disclosed utilizes one or more microprocessors to execute a computer-program that is embodied in a non-transitory computer readable medium that is programmed to perform any number of the functions as disclosed. Further, the controller(s) as provided herein includes a housing and the various number of microprocessors, integrated circuits, and memory devices ((e.g., FLASH, random access memory (RAM), read only memory (ROM), electrically programmable read only memory (EPROM), electrically erasable programmable read only memory (EEPROM)) positioned within the housing. The controller(s) as disclosed also include hardware-based inputs and outputs for receiving and transmitting data, respectively from and to other hardware-based devices as discussed herein.

While exemplary embodiments are described above, it is not intended that these embodiments describe all possible forms of the invention. Rather, the words used in the specification are words of description rather than limitation, and it is understood that various changes may be made without departing from the spirit and scope of the invention. Additionally, the features of various implementing embodiments may be combined to form further embodiments of the invention.

### Further Examples:

Example 1. An audio system comprising: an audio arrangement including electronics and being programmed to: transmit an audio output signal via at least one loudspeaker in response to an audio input signal; a power management circuit including at least one first switch being operably coupled to at least one battery, the power management circuit being configured to transmit a voltage from the at least one battery to the audio arrangement to power the audio arrangement to transmit the audio output signal; and at least one controller programmed to selectively activate the at least one first switch to charge a capacitor in a vehicle to a predetermined charge level to prevent an in-rush of current from being delivered to the electronics of the audio arrangement while the at least one battery experiences a fault condition.

Example 2. The audio system of example 1, wherein the fault condition corresponds to a short to battery condition.

Example 3. The audio system of example 1 or 2, wherein the predetermined charge level corresponds to a charge value of between 50% and 80%.

Example 4. The audio system of any of examples 1 to 3, wherein the electronics of the audio arrangement includes a second switch and a third switch.

Example 5. The audio system of any of examples 1 to 4, wherein the at least one controller is further programmed to selectively activate the at least one first switch to charge the capacitor to the predetermined charge level to prevent the in-rush of current from being delivered to the first switch and the second switch.

Example 6. The audio system of any of examples 1 to 5, wherein a power management circuit further includes a diode positioned in parallel with the first switch, and configured to: in response to the at least one battery experiencing the fault condition, block a majority amount of current from the at least one battery being transferred to the electronics of the audio arrangement such that only a small amount of current within a threshold is allowed to pass through.

Example 7. The audio system of example 6 wherein the diode is a Schottky diode.

Example 8. A system comprising: an audio arrangement including electronics and being programmed to transmit an audio output signal via at least one loudspeaker in response to an audio input signal; a power management circuit including a first plurality of switches and a diode being operably coupled to at least one battery, the power management circuit being configured to transmit a voltage from the at least one battery to the audio arrangement to power the audio arrangement to transmit the audio output signal; and at least one controller programmed to selectively deactivate the first plurality of switches to enable a current from the at least one battery to be delivered to the diode of the power management circuit to prevent an in-rush of current from being delivered to the electronics of the audio arrangement while the at least one battery experiences a fault condition.

Example 9. The system of example 8, wherein the fault condition corresponds to a short to battery condition.

Example 10. The system of example 8 or 9, wherein the first plurality of switches includes a first switch and a second switch, and wherein the diode is positioned in parallel with the first switch and the second switch.

Example 11. The system of any of examples 8 to 10, wherein the diode is a Schottky diode.

Example 12. The system of any of examples 8 to 11, wherein the diode blocks current from the at least one battery in response to the battery experiencing a short to battery condition.

Example 13. The system of example 12, wherein the diode blocks a majority of the current from the at least one battery such that the remainder of the current reaching the electronics is insufficient to cause any damage.

Example 14. A method for an audio system, comprising: selectively activating one or more of a plurality of switches of a power management circuit to charge a capacitor to a predetermined charge level, wherein the capacitor is connected between the power management circuit and an audio arrangement; and responsive to detecting a battery experiencing a fault condition, deactivate one or more of a plurality of switches of the power management circuit such that a current flowing from the battery to the audio arrangement through the power management circuit and the capacitor is within a threshold insufficient to cause damage to the audio arrangement.

Example 15. The method of example 14, wherein the power management circuit includes the plurality of switches connected in series.

Example 16. The method of example 15, wherein the power management circuit further includes a diode connected in parallel with the plurality of switches, the diode is configured to in response to the battery experiencing the fault condition, block a majority amount of current from the battery being transferred to the audio arrangement such that the remainder of the current reaching the audio arrangement is insufficient to cause damage.

Example 17. The method of example 16, wherein the diode is a Schottky diode.

Example 18. The example of any of examples 14 to 17, wherein the fault condition corresponds to a short to battery condition.

Example 19. The method of any of examples 14 to 18, wherein the predetermined charge level corresponds to a charge value of between 50% and 80%.

## Claims

1. An audio system comprising:
an audio arrangement including electronics and being programmed to:
transmit an audio output signal via at least one loudspeaker in response to an audio input signal;
a power management circuit including at least one first switch being operably coupled to at least one battery, the power management circuit being configured to transmit a voltage from the at least one battery to the audio arrangement to power the audio arrangement to transmit the audio output signal; and
at least one controller programmed to selectively activate the at least one first switch to charge a capacitor in a vehicle to a predetermined charge level to prevent an in-rush of current from being delivered to the electronics of the audio arrangement while the at least one battery experiences a fault condition.

2. The audio system of claim 1, wherein the fault condition corresponds to a short to battery condition.

3. The audio system of claim 1, wherein the predetermined charge level corresponds to a charge value of between 50% and 80%.

4. The audio system of claim 1, wherein the electronics of the audio arrangement includes a second switch and a third switch.

5. The audio system of claim 4, wherein the at least one controller is further programmed to selectively activate the at least one first switch to charge the capacitor to the predetermined charge level to prevent the in-rush of current from being delivered to the first switch and the second switch.

6. The audio system of claim 1, wherein a power management circuit further includes a diode positioned in parallel with the first switch, and configured to:
in response to the at least one battery experiencing the fault condition, block a majority amount of current from the at least one battery being transferred to the electronics of the audio arrangement such that only a small amount of current within a threshold is allowed to pass through.

7. The audio system of claim 6, wherein the diode is a Schottky diode.

8. A method for an audio system, comprising:
selectively activating one or more of a plurality of switches of a power management circuit to charge a capacitor to a predetermined charge level, wherein the capacitor is connected between the power management circuit and an audio arrangement; and
responsive to detecting a battery experiencing a fault condition, deactivate one or more of a plurality of switches of the power management circuit such that a current flowing from the battery to the audio arrangement through the power management circuit and the capacitor is within a threshold insufficient to cause damage to the audio arrangement.

9. The method of claim 8, wherein the power management circuit includes the plurality of switches connected in series.

10. The method of claim 9, wherein the power management circuit further includes a diode connected in parallel with the plurality of switches, the diode is configured to in response to the battery experiencing the fault condition, block a majority amount of current from the battery being transferred to the audio arrangement such that the remainder of the current reaching the audio arrangement is insufficient to cause damage.

11. The method of claim 10, wherein the diode is a Schottky diode.

12. The method of claim 8, wherein the fault condition corresponds to a short to battery condition.

13. The method of claim 8, wherein the predetermined charge level corresponds to a charge value of between 50% and 80%.
